# EUROPEAN PATENT SPECIFICATION

(11) **EP 2 913 358 B1**
(45) Date of publication and mention of the grant of the patent: **31.01.2018**
(21) Application number: 13849902.5
(22) Date of filing: 22.10.2013
(51) Int. Cl.: C08L 23/08, C08F 8/42, H01L 31/042, C08L 51/06, H01L 31/048, H01L 31/049

(54) **RESIN COMPOSITION FOR SOLAR CELL ENCAPSULANT MATERIALS**
HARZZUSAMMENSETZUNG FÜR SOLARZELLENVERKAPSELUNGSMATERIALIEN
COMPOSITION DE RÉSINE POUR MATÉRIAUX D'ENCAPSULATION POUR CELLULES SOLAIRES

(30) Priority: 23.10.2012 JP 2012233519
(43) Date of publication of application: 02.09.2015
(73) Proprietor: JNC Corporation, Chiyoda-ku Tokyo 100-8105 (JP); JNC Petrochemical Corporation, Tokyo 100-0004 (JP)
(72) Inventor: TOYAMA, Minoru, Ichihara-shi Chiba 290-8551 (JP); FUKUDA, Hirokazu, Ichihara-shi Chiba 290-8551 (JP); KOGA, Shin, Ichihara-shi Chiba 290-8551 (JP)
(74) Representative: Müller-Boré & Partner Patentanwälte PartG mbB
(86) International application number: PCT/JP2013/078516
(87) International publication number: WO 2014/065251

(56) References cited:
- EP-A1- 1 000 973
- EP-A1- 2 600 418
- WO-A1-2012/014965
- JP-A- 2001 332 750
- JP-A- 2010 059 277
- JP-A- 2011 153 318
- JP-A- 2012 015 402
- US-A- 5 223 311
- US-A1- 2010 126 557
- US-A1- 2012 048 354

## Description

### Technical Field

The invention relates to a material for sealing a solar cell device in a solar cell module. More specifically, the invention relates to a resin composition for a solar cell encapsulant material that facilitates formation of a solar cell module and recycling of a solar sell device, and has excellent transparency, heat resistance and processing characteristics.

### Background Art

While an environmental issue has been heightened in recent years, utilization of clean energy such as hydraulic power generation, wind power generation and photovoltaic power generation using natural energy has attracted attention. In particular, the photovoltaic power generation has been significantly diffused due to progress of project for promotion of photovoltaic power generation system by the national and local governments.

A solar cell module generally has structure in which a solar cell device made of silicon or the like is placed between a protective material formed of a transparent substrate such as glass on a side of a light-receiving surface side, and a protective material (backsheet) formed of a moisture-impermeable plastic film such as PVF or PET on a side of a light-non-receiving surface, and a clearance between the solar cell device and the protective materials arranged on both sides of the device is filled and sealed with a encapsulant material formed of a transparent thermoplastic.

The encapsulant material used in the solar cell module is mainly required to have characteristics such as flexibility, heat resistance, transparency and durability for protection of the solar cell device from impact, a countermeasure against heat generation in the module, efficient utilization of solar light, and a use environment such as long-term outdoor use. The solar cell module is used under various environments, and the characteristics required therefor differ depending on the use environment in several cases. In the solar cell module for space in an artificial satellite, for example, a panel temperature during use reputedly varies in the range of -100°C to 120°C. In a general use environment, the panel temperature of the solar cell module during use is confirmed to reach 70 to 80°C.

For the encapsulant material for the solar cell module, an ethylene-vinyl acetate copolymer is mainly used currently from viewpoints of the transparency and the flexibility (Patent literature No. 1). However, in order to supplementarily provide the heat resistance, a encapsulant material of a type subjected to crosslinking treatment by an organic peroxide is used therefor. Upon producing the solar cell module, the crosslinking-type encapsulant material needs to be crosslinked in a lamination step for sealing the solar cell device. Therefore, upon producing a encapsulant raw material containing the organic peroxide and producing a encapsulant sheet from the raw material, preparation of such a material is required at a temperature at which no organic peroxide decomposes. Consequently, an increase in a production speed has been quite difficult due to shaping at a low temperature in production step thereof. Further, the lamination step for sealing the solar cell device requires about 15 to 60 minutes as a crosslinking period of time, and production of the solar cell device has required a long period of time and many man-hours.

Further, as described above, the crosslinking treatment is applied to a solar cell encapsulant material in which the ethylene-vinyl acetate copolymer is used. Thus, when reuse of the solar cell module is taken into consideration, removal of the encapsulant material is difficult and recycling of the solar cell device becomes difficult. While enormous growth in a solar cell market is expected in the future, development of environmental cycling clean energy is required, and technical development on the reuse has been desired for each member used in the solar cell module.

For the problems described above, as the solar cell encapsulant material without needing crosslinking, Patent literature No. 2 discloses an adhesive sheet formed of a modified ethylene-based resin that contains alkoxysilane as a copolymerization component, and has a melting point from 80°C to 120°C. Meanwhile, Patent literature No. 3 discloses a solar cell encapsulant material formed of a resin composition containing a specific ethylene-α-olefin random copolymer and a specific ethylene-α-olefin block copolymer.

Moreover, as described above, the solar cell encapsulant material is required to have light resistance depending on the use environment thereof. In order to provide the material with the light resistance, a technique of adding a light-resistant agent such as an ultraviolet light absorber and a light stabilizer thereto is generally applied. Meanwhile, if moisture infiltrates into an inside of the solar cell module, the infiltration is known to cause a decrease in output of the solar cell. If adhesion between the protective material on the side of the light-receiving surface, and the encapsulant material is insufficient, an interface therebetween is detached and moisture intrudes thereinto to adversely affect the solar cell. As a method for increasing the adhesion between the transparent protective material such as the glass plate, and the encapsulant material, use of a silane-modified resin subjected to silane coupling treatment or the like is generally known.

Patent literature No. 4 discloses an example in which a silane coupling agent and a NOR-type hindered amine flame retardant are added to an ethylene-butene copolymer.

### Citation List

### Patent Literature

Patent literature No. 1: JP S58-63178 A.
Patent literature No. 2: JP 2002-235048 A.
Patent literature No. 3: JP 2011-040735 A.
Patent literature No. 4: JP 2012-015402 A.

### Summary of Invention

### Technical Problem

A problem of a solar cell encapsulant material using an ethylene-vinyl acetate copolymer is expected to be improved by using a material described in each Patent literature described above. However, the invention described in Patent literature No. 2 relates to an improvement of transparency, heat resistance and processing characteristics, but no specific examples are described and an effect thereof has been unclear in several respects. Moreover, the invention described in Patent literature No. 3 has substantial features of using an ethylene-octene block copolymer and an ethylene-octene random copolymer or an ethylene-propylene-hexene ternary random copolymer, and among the copolymers, the ethylene-octene block copolymer has had a problem of lack in versatility.

An object of the invention is to provide a solar cell encapsulant material that requires no crosslinking by an organic peroxide, can easily form a solar cell module and facilitates recycling of a solar cell device, and is excellent in various characteristics such as heat resistance and transparency.

### Solution to Problem

The present inventors have diligently continued to conduct study to solve the problem described above, and as a result, have found that a sheet formed of an ethylene-based resin composition containing ethylene-unsaturated fatty acid ester copolymer (A) having a melting point in a specific range, and at least one kind of copolymer (B) selected from an ethylene-olefin copolymer having a melting point in a specific range and a copolymer obtained by silane-modifying the ethylene-olefin copolymer satisfies characteristics required for a solar cell encapsulant material, such as heat resistance and transparency, and thus have arrived at the invention.

More specifically, the invention is as described below.
[1] A resin composition for a solar cell encapsulant material, containing: 5 to 30% by weight of ethylene-unsaturated fatty acid ester copolymer (A) having a crystal melting peak temperature of 95 to 110°C as measured at a heating rate of 10°C/min in differential scanning calorimetry, and having an unsaturated fatty acid ester content of 10 to 23% by weight; and 95 to 70% by weight of at least one kind of copolymer (B) selected from ethylene-olefin random copolymer (b-1) having a crystal melting peak temperature lower than 80°C, and copolymer (b-2) obtained by copolymerizing alkoxysilane having a polymerizable functional group and the ethylene-olefin random copolymer (b-1).
[2] The resin composition for the solar cell encapsulant material according to [1], wherein ethylene-unsaturated fatty acid ester copolymer (A) is an ethylene-alkyl acrylate copolymer.
[3]. The resin composition for the solar cell encapsulant material according to [1] or [2], wherein ethylene-unsaturated fatty acid ester copolymer (A) is an ethylene-ethyl acrylate copolymer.
[4] The resin composition for the solar cell encapsulant material according to any one of [1] to [3], wherein the copolymer (B) is the ethylene-olefin random copolymer (b-1).
[5] The resin composition for the solar cell encapsulant material according to any one of [1] to [3], wherein the copolymer (B) is copolymer (b-2) obtained by copolymerizing alkoxysilane having a polymerizable functional group and the ethylene-olefin random copolymer (b-1).
[6] The resin composition for the solar cell encapsulant material according to any one of [1] to [3] and [5], further containing a weakly basic stabilizer.
[7] A solar cell encapsulant material obtained by shaping the resin composition for the solar cell encapsulant material according to any one of [1] to [6].
[8] A solar cell module obtained by using the solar cell encapsulant material according to [7].

### Advantageous Effects of Invention

A resin composition for a solar cell encapsulant material according to the invention can provide a solar cell encapsulant material having excellent heat resistance and transparency, and a solar cell module prepared by using the solar cell encapsulant material.

Moreover, the composition is of a non-crosslinking type, and thus an improvement in recycling efficiency of various members that form the solar cell module, such as a cell, and a significant improvement in productivity of the solar cell module without needing a crosslinking step are expected.

### Description of Embodiments

The invention will be specifically described below.

A resin composition for a solar cell encapsulant material according to the invention contains: 5 to 30% by weight of ethylene-unsaturated fatty acid ester copolymer (A) having a crystal melting peak temperature of 95 to 110°C as measured at a heating rate of 10°C/min in differential scanning calorimetry (hereinafter, referred to simply as a crystal melting peak temperature), and having an unsaturated fatty acid ester content of 10 to 23% by weight; and 95 to 70% by weight of at least one kind of copolymers (B) selected from ethylene-olefin random copolymer (b-1) having a crystal melting peak temperature lower than 80°C, and copolymer (b-2) obtained by copolymerizing alkoxysilane having a polymerizable functional group, and the ethylene-olefin random copolymer (b-1).

### Ethylene-unsaturated fatty acid ester copolymer (A)

Ethylene-unsaturated fatty acid ester copolymer (A) used in the invention is not particularly limited, if a crystal melting peak temperature satisfies the range of 95 to 110°C.

From a viewpoint of preferably adjusting the crystal melting peak temperature of copolymer (A), an unsaturated fatty acid ester content in ethylene-unsaturated fatty acid ester copolymer (A) is 10 to 23% by weight, further preferably, 12 to 20% by weight, and particularly preferably, 15 to 20% by weight. If the unsaturated fatty acid ester content increases in ethylene-unsaturated fatty acid ester copolymer (A), the crystal melting peak temperature decreases.

Specific examples of the unsaturated fatty acid ester include alkyl (meth)acrylate. The number of carbon atoms in alkyl of alkyl (meth)acrylate is ordinarily 1 to 5.

Specific examples of such alkyl (meth)acrylate include methyl (meth)acrylate, ethyl (meth)acrylate, propyl (meth)acrylate and butyl (meth)acrylate.

Specific examples of a copolymer of alkyl (meth)acrylate and ethylene include an ethylene-methyl acrylate copolymer, an ethylene-methyl methacrylate copolymer, an ethylene-ethyl acrylate copolymer and an ethylene-butyl acrylate copolymer.

The ethylene-unsaturated fatty acid ester copolymers may be used alone, or in combination of two or more kinds.

In the invention in particular, as ethylene-unsaturated fatty acid ester copolymer (A) described above, the ethylene-ethyl acrylate copolymer is preferably used because such an ethylene-ethyl acrylate copolymer has an excellent balance between heat resistance and transparency.

Such ethylene-unsaturated fatty acid ester copolymer (A) can be ordinarily produced by multistage polymerization by applying a tubular method or a stirring autoclave method in a high-pressure radical polymerization method. In particular, a polymer obtained by the tubular method has high heat resistance and retained transparency, and therefore is preferred. Specific examples of the methods for producing the copolymers include methods disclosed in JP S62-273214 A and JP 2002-505692 A.

In addition, the crystal melting peak temperature of the ethylene-unsaturated fatty acid ester copolymer can be adjusted by changing conditions during production, for example, a content or a kind of a copolymerization monomer. Specifically, a case of increasing the temperature can be achieved by decreasing a copolymerization monomer content.

A melt index (MI) of ethylene-unsaturated fatty acid ester copolymer (A) used in the invention is not particularly limited, but in view of securing film-forming properties for a sheet and flowability during sealing a solar cell device, MI (JIS K7210, temperature: 190°C, load: 21.18 N) is preferably 0.1 to 50 g/10 min, and further preferably, 0.5 to 30 g/10 min.

Specific examples of a method for adjusting the melt index of the ethylene-unsaturated fatty acid ester copolymer include adjustment of a polymerization degree or a molecular weight distribution of the polymer, and in order to increase the melt index, a decrease in the polymerization degree of the polymer and a decrease in the molecular weight.

The crystal melting peak temperature of ethylene-unsaturated fatty acid ester copolymer (A) used in the invention is preferably in the range of 95 to 110°C, and further preferably, 98 to 108°C. It the temperature is within the range, the heat resistance and the transparency of the solar cell encapsulant material are maintained, and therefore such a range is preferred. The crystal melting peak temperature can be measured according to JIS K7122 using a differential scanning calorimeter except that a heating rate is adjusted to 10°C/min. On the occasion, when two or more melting point peaks exist, a higher temperature is taken as a melting point.

Density (JIS K7112) of ethylene-unsaturated fatty acid ester copolymer (A) used in the invention is different depending on kinds of unsaturated fatty acid ester composing ethylene-unsaturated fatty acid ester copolymer (A). The density corresponds to the unsaturated fatty acid ester content of 10 to 23% by weight. When the unsaturated fatty acid ester is ethyl acrylate, the density is preferably in the range of 0.928 to 0.933 g/cm³, and further preferably, 0.930 to 0.932 g/cm³. If the density is within the range described above, the heat resistance and the transparency of the solar cell encapsulant material are maintained, and therefore such density is preferred.

### Copolymer (B)

### Ethylene-olefin random copolymer (b-1)

Ethylene-olefin random copolymer (b-1) used in the invention is not particularly limited, if the crystal melting peak temperature thereof satisfies a condition of lower than 80°C. A random copolymer of ethylene and an olefin having 3 to 20 carbons is ordinarily preferably used. Specific examples of the olefin to be copolymerized with ethylene include propylene, 1-butene, 1-pentene, 1-hexene, 1-heptene, 1-octene, 1-nonene, 1-decene and 3-methyl-butene-1 and 4-methyl-pentene-1. In the invention, from viewpoints of ease of industrial availability, various characteristics and so forth, propylene, 1-butene, 1-hexene and 1-octene are preferably used as the olefin to be copolymerized with ethylene. The olefins to be copolymerized with ethylene may be used alone, or in combination of two or more kinds.

In addition, the crystal melting peak temperature of the ethylene-olefin random copolymer can be adjusted by changing conditions during production, for example, a content or a kind of a copolymerization monomer. Specifically, a case of increasing the temperature can be achieved by decreasing the copolymerization monomer content.

A content of the olefin to be copolymerized with ethylene is not particularly limited, but is preferably 3 to 30 mol% or less based on the total monomer unit in ethylene-olefin random copolymer (b-1), and further preferably, 5 to 25 mol% based thereon. If the olefin content is within the range described above, crystallinity is reduced by a copolymerization component to improve the flexibility and to be difficult in causing a defect such as blocking of raw material pellets, and therefore such a content is preferred.

The melt index (MI) of ethylene-olefin random copolymer (b-1) used in the invention is not particularly limited, but in view of the film-forming properties for the sheet and the flowability during sealing the solar cell device, MI (JIS K7210, temperature: 190°C, load: 21.18 N) is preferably 0.1 to 50 g/10 min, and further preferably, 0.5 to 30 g/10 min.

Specific examples of a method for adjusting the melt index of the ethylene-olefin random copolymer include adjustment of a polymerization degree or a molecular weight distribution of the polymer, and in order to increase the melt index, a decrease in the polymerization degree of the polymer.

Density (JIS K7112) of ethylene-olefin random copolymer (b-1) used in the invention is preferably 0.890 g/cm³ or less, and further preferably, 0.870 to 0.888 g/cm³. If the density is within the range described above, the solar cell encapsulant material has excellent transparency and blocking properties, and therefore such density is preferred.

Ethylene-olefin random copolymer (b-1) may be used alone or in combination of two or more kinds.

A method for producing ethylene-olefin random copolymer (b-1) used in the invention is not particularly limited, and copolymer (b-1) can be produced by a publicly known polymerization method using a publicly known olefin polymerization catalyst. For example, copolymer (b-1) can be produced by a slurry polymerization method, a solution polymerization method, a bulk polymerization method, a gas-phase polymerization method or the like using a multisite catalyst such as a Ziegler-Natta catalyst, or a single site catalyst such as a metallocene catalyst. As the method for producing ethylene-olefin random copolymer (b-1) in the invention, from viewpoints of ease of producing raw material pellets and the sheet for the solar cell encapsulant material, prevention of blocking and so forth, a polymerization method using the single site catalyst from which a polymer having only a small amount of low molecular weight components and a narrow molecular weight distribution is obtained is preferably applied.

The crystal melting peak temperature of ethylene-olefin random copolymer (b-1) used in the invention satisfies a level lower than 80°C, and is further preferably, 55 to 75°C. If the temperature is within the range described above, the solar cell encapsulant material having excellent transparency and blocking properties is obtained, and therefore such a temperature is preferred.

### Copolymer (b-2) obtained by silane-modifying ethylene-olefin random copolymer (b-1)

Copolymer (b-2) of the invention is used for providing the encapsulant material with adhesion to a protective material on a side of a light-receiving surface, such as glass, and a copolymer of alkoxysilane having the polymerizable functional group, and ethylene-olefin random copolymer (b-1) described above is used.

A melting point of copolymer (b-2) used in the invention is preferably lower than 80°C, and further preferably, 55 to 75°C because, when the melting point of copolymer (b-2) is within the range described above, the solar cell encapsulant material has excellent transparency.

The melting point of copolymer (b-2) can be adjusted by adjusting a kind or an amount of ethylene-olefin random copolymer (b-1) and alkoxysilane having the polymerizable functional group to be used for obtaining copolymer (b-2).

The melt index (MI) of copolymer (b-2) used in the invention is not particularly limited, but in view of the film-forming properties for the sheet and the flowability during sealing the solar cell device or the like, MI (JIS K7210, temperature: 190°C, load: 21.18 N) is preferably 0.1 to 50 g/10 min, and further preferably, 0.5 to 30 g/10 min.

For preparation of copolymer (b-2) described above, the ethylene-olefin random copolymer (b-1) and alkoxysilane having the polymerizable functional group are used, and specific examples of such alkoxysilane having the polymerizable functional group include an ethylenic unsaturated silane compound. The ethylenic unsaturated silane compound is not particularly limited if the compound causes graft polymerization with the ethylene-olefin random copolymer (b-1). For example, at least one kind of compound selected from the group of vinyltrimethoxysilane, vinyltriethoxysilane, vinyltripropoxysilane, vinyltriisopropoxysilane, vinyltributoxysilane, vinyltripentyloxysilane, vinyltriphenoxysilane, vinyltribenzyloxysilane, vinyltrimethylenedioxysilane, vinyltriethylenedioxysilane, vinylpropionyloxysilane, vinyltriacetoxysilane and vinyltricarboxysilane can be used. Above all, vinyltrimethoxysilane and vinyltriethoxysilane are preferably used.

When copolymer (b-2) is incorporated into the resin composition for the solar cell encapsulant material to be used in the invention, copolymer (b-2) is prepared or added to 0.1 to 5% by weight in the content of the ethylenic unsaturated silane compound in the resin composition for the solar cell encapsulant material, and further preferably, copolymer (b-2) is prepared or added to be 0.5 to 3% by weight in the content. If the content of the ethylenic unsaturated silane compound is within the range, the resultant composition has excellent adhesion with the protective material on the side of the light-receiving surface and so forth, and is also advantageous in terms of cost.

Moreover, copolymer (b-2) used in the invention can be obtained by a publicly known method such as a method of mixing the ethylenic unsaturated silane compound being alkoxysilane having the polymerizable functional group, ethylene-olefin random copolymer (b-1) and a radical generator, and heating, melting and kneading the resultant mixture in an extruder. Specific examples of the radical generator include: hydroperoxides such as diisopropylbenzene hydroperoxide and 2,5-dimethyl-2,5-di(hydroperoxy)hexane; dialkyl peroxides such as di-t-butyl peroxide, t-butylcumyl peroxide, dicumyl peroxide, 2,5-dimethyl-2,5-di-(t-butyl peroxy)hexane; diacyl peroxides such as bis-3,5,5-trimethylhexanoyl peroxide, octanoyl peroxide, benzoyl peroxide, o-methylbenzoylperoxide and 2, 4-dichlorobenzoyl peroxide; peroxy esters such as t-butyl peroxyacetate, t-butyl peroxy-2-ethylhexanoate, t-butyl peroxyperpivalate, t-butyl peroxyoctate, t-butyl peroxyisopropylcarbonate, t-butyl peroxybenzoate, di-t-butyl peroxyphthalate, 2,5-dimethyl-2,5-di(benzoylperoxy)hexane and 2,5-dimethyl-2,5-di(benzoylperoxy)hexyne-3; organic peroxides such as ketone peroxides including methyl ethyl ketone peroxide and cyclohexanon peroxide; or azo compounds such as azobisisobutyronitrile and azobis(2,4-dimethylvaleronitrile).

In addition, when the radical generator described above is used, the radical generator is decomposed during synthesis of copolymer (b-2), and no radical generator is substantially contained in copolymer (b-2) .

In view of a graft reaction between the ethylenic unsaturated silane compound being alkoxysilane having the polymerizable functional group, and ethylene-olefin random copolymer (b-1), an amount of adding the radical generator described above is preferably 0.01 to 0.5% by weight, and further preferably, 0.03 to 0.2% by weight, based on ethylene-olefin random copolymer (b-1).

The copolymer (b-2) may be contained wholly in the solar cell encapsulant material. However, from an economic aspect, a plurality of layers constituting the solar cell encapsulant material are arranged, and copolymer (b-2) is preferably incorporated into only a surface layer . Further, when recycling efficiency of the solar cell device is taken into consideration, copolymer (b-2) is preferably incorporated into only the surface layer on a side of the glass substrate.

### Resin composition for solar cell encapsulant material

The resin composition for the solar cell encapsulant material according to the invention contains ethylene-unsaturated fatty acid ester copolymer (A) described above, and at least one kind of copolymer (B) selected from ethylene-olefin random copolymer (b-1), and copolymer (b-2) obtained by copolymerizing alkoxysilane having the polymerizable functional group and the ethylene-olefin random copolymer (b-1). A content ratio of ethylene-unsaturated fatty acid ester copolymer (A) and at least one kind of copolymer (B) selected from ethylene-olefin random copolymer (b-1) and copolymer (b-2) in the resin composition for the solar cell encapsulant material according to the invention is preferably 5 to 30 / 95 to 70% by weight, and further preferably, 10 to 20 / 90 to 80% by weight. If the content ratio is within the range described above, the solar cell encapsulant material having excellent heat resistance and transparency is obtained, and therefore such a content ratio is preferred.

Moreover, when both of ethylene-olefin random copolymer (b-1) and silane-modified ethylene-olefin random copolymer (b-2) are incorporated into the resin composition for the solar cell encapsulant material of the present invention as copolymer (B) to be incorporated thereinto, both are incorporated thereinto to be ordinarily 0.1 : 99.9 to 98.6 : 1.4, and preferably, 0.1 : 99.9 to 47.5 : 52.5 in terms of a weight ratio thereof.

From a viewpoint of compatibility between the resins, a ratio of the melt index (MI) of ethylene-olefin random copolymer (b-1) to the melt index (MI) of ethylene-unsaturated fatty acid ester copolymer (A) used in the invention is preferably 1 : 20 to 20 : 1, and further preferably, 1 : 10 to 10 : 1. Moreover, from a viewpoint of compatibility between the resins, a ratio of the melt index (MI) of ethylene-olefin random copolymer (b-2) to the melt index (MI) of ethylene-unsaturated fatty acid ester copolymer (A) is preferably 1 : 20 to 20 : 1, and further preferably, 1:10 to 10:1. Moreover, when both of the ethylene-olefin random copolymer (b-1) and the copolymer (b-2) are incorporated into the composition of the invention, from a viewpoint of compatibility between the resins, a ratio of the melt index (MI) of the copolymer (b-2) to the melt index (MI) of ethylene-random copolymer (b-1) is preferably 1 : 20 to 20 : 1, and further preferably, is 1 : 10 to 10 : 1. If the MI ratio is within the range described above, the solar cell encapsulant material having excellent transparency is obtained, and therefore such a ratio is preferred.

A case where no substantial incorporation of the radical generator is made into the resin composition for the solar cell encapsulant material according to the invention causes no necessity of the crosslinking step during preparation of the solar cell module and contributes to an improvement in recycling efficiency of the encapsulant material, and therefore such a case is preferred.

In addition, no substantial incorporation herein means a case where the content of the radical generator is less than 0.001% by weight in the resin composition for the solar cell encapsulant material.

Moreover, when necessary, various kinds of additives such as an antioxidant, a light stabilizer, an ultraviolet light absorber, a nucleating agent, a pigment, a flame retardant and a discoloration inhibitor can be added to the resin composition for the solar cell encapsulant material according to the invention because characteristics described later can be obtained by adding such additives.

### (Antioxidant)

The antioxidant used in the invention is applied in order to prevent oxidative deterioration of the solar cell encapsulant material. Specific examples of a phenolic antioxidant include monophenols (2,6-di-t-butyl-p-cresol, butylated hydroxyanisole, 2,6-di-t-butyl-p-ethylphenol and stearyl-β-(3,5-di-t-butyl-4-hydroxyphenyl)propionate), bisphenols (2,2'-methylenebis(4-methyl-6-t-butylphenol), 2,2'-methylenebis(4-ethyl-6-t-butylphenol), 4,4'-thiobis(3-methyl-6-t-butylphenol), 4,4'-butylidenebis(3-methyl-6-t-butylphenol) and 3,9-bis[1,1-dimethyl-2-{β-(3-t-butyl-4-hydroxy-5-methylphenyl)prop ionyloxy}ethyl]2,4,8,10-tetraoxaspiro[5,5]undecane), and polymer-type phenols (1,1,3-tris(2-methyl-4-hydroxy-5-t-butylphenyl)butane, 1,3,5-trimethyl-2,4,6-tris(3,5-di-t-butyl-4-hydroxybenzyl)benzene, tetrakis-[methylene-3-(3' ,5'-di-t-butyl-4'-hydroxyphenyl)propionat e]methane, bis[3,3'-bis-(4'-hydroxy-3'-t-butylphenyl)butyric acid] glycol ester, 1,3,5-tris(3',5'-di-t-butyl-4'-hydroxybenzyl)-S-triazine-2,4,6-(1H ,3H,5H)trione and tocopherol), and sulfur antioxidants dilauryl-3,3'-thiodipropionate, dimyristyl-3,3'-thiodipropionate and distearyl-3,3'-thiodipropionate. Specific examples of a phosphoric antioxidant include phosphites (diphenyl phosphite, diphenylisodecyl phosphite, phenyl di-isodecyl phosphite, tris(nonylphenyl)phosphite, diisodecylpentaerythritol phosphite, tris(2,4-di-t-butylphenyl)phosphite, cyclic neopentane-tetraylbis(octadecyl)phosphite, cyclic neopentane-tetraylbis(2,4-di-t-butylphenyl)phosphite, cyclic neopentane-tetraylbis(2,4-di-t-butyl-6-methylphenyl)phosphite and bis[2-t-butyl-6-methyl-4-{2-(octadecyloxycarbonyl)ethyl}phenyl]hyd rogenphosphite), and oxaphosphaphenanthrene oxides (9,10-dihydro-9-oxa-10-phosphaphenanthrene-10-oxide, 10-(3,5-di-t-butyl-4-hydroxybenzyl)-9,10-dihydro-9-oxa-10-phosphap henanthrene-10-oxide and 10-decyloxy-9,10-dihydro-9-oxa-10-phosphaphenanthrene-10-oxide).

The antioxidants described above each can be used alone, but are particularly preferably used in combination with phenol/sulfur or phenol/phosphorus antioxidants. As a commercially available phenol antioxidant, IRGANOX 1010 (trade name) made by BASF Japan Ltd., and as a phosphoric antioxidant, IRGAFOS 168 (trade name) made by BASF Japan Ltd. can be used alone, or mixed and used.

A content of the antioxidant used in the invention is preferably in the range of 0.01 to 0.5% by weight, and further preferably, in the range of 0.03 to 0.3% by weight, based on the total amount of the resin composition for the solar cell encapsulant material.

### (Light stabilizer)

The light stabilizer used in the invention is applied to scavenge a radical generated in the solar cell encapsulant material by ultraviolet light, and prevent photooxidation. Specific examples of the light stabilizer include dimethyl-succinate-1-(2-hydroxyethyl)-4-hydroxy-2,2,6,6-tetramethy lpiperidine polycondensate, poly[{6-(1,1,3,3-tetramethylbutyl)amino-1,3,5-triazine-2,4-diyl}{( 2,2,6,6-tetramethyl-4-piperidyl)imino}hexamethylene{{2,2,6,6-tetra methyl-4-piperidyl}imino}], N,N'-bis(3-aminopropyl)ethylenediamine-2,4-bis[N-butyl-N-(1,2,2,6, 6-pentamethyl-4-piperidyl)amino]-6-chloro-1,3,5-triazine condensate, bis(2,2,6,6-tetramethyl-4-piperidyl)sebacate, bis(1,2,2,6,6-pentamethyl-4-piperidyl), TINUVIN XT850 (trade name, BASF Japan Ltd.), bis(1,2,2,6,6-pentamethyl-4-piperidyl)[[3,5-bis(1,1-dimethylethyl) -4-hydroxyphenyl]methyl]butylmalonate, bis(1-undecanoxy-2,2,6,6-tetramethylpiperidine-4-yl) carbonate, a reaction product of peroxidation-treated 4-butylamino-2,2,6,6-tetramethylpiperidine, 2,4,6-trichloro-1,3,5-triazine and cyclohexane, and N,N'-ethane-1,2-diylbis(1,3-propanediamine), and a hindered amine compound such as 1,3,5-triazine-2,4,6-triamine and N2,N2"-1,2-ethanediylbis[N2-[3-[[4,6-bis[butyl(1,2,2,6,6-pentameth yl-4-piperidinyl)amino]-1,3,5-triazine-2-yl]amino]propyl)]-N',N"-d ibutyl-N',N"-bis(1,2,2,6-pentamethyl-4-piperidinyl) .

When copolymer (b-2) is used as copolymer (B) composing the resin composition for the solar cell encapsulant material according to the invention, a weakly basic light stabilizer having a specific structural formula is preferably incorporated into the resin composition for the solar cell encapsulant material. As the weakly basic light stabilizer having the specific structural formula, a weakly basic hindered amine compound having a specific structural formula can be used, for example, a N-methyl-type hindered amine compound having a 1,2,2,6,6-pentamethyl-4-piperidyl group, or an NOR-type hindered amine compound having a group shown by the following formula (1).

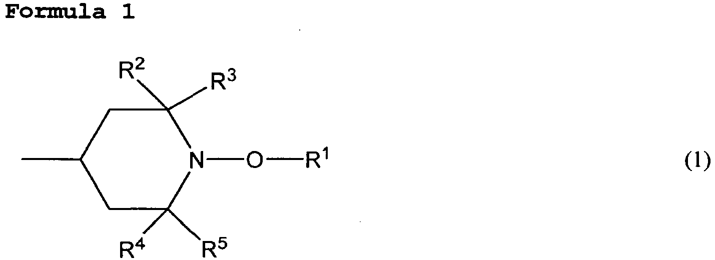

In formula (1), R¹ represents alkyl having 1 to 18 carbons or cycloalkyl having 5 to 12 carbons, and R², R³, R⁴ and R⁵ each independently represent alkyl having 1 to 4 carbons.

Specific examples of an N-methyl-type hindered amine compound having a 1,2,2,6,6-pentamethyl-4-piperidyl group include bis(1,2,2,6,6-pentamethyl-4-piperidyl) [[3,5-bis(1,1-dimethylethyl) -4-hydroxyphenyl]methyl] butyl malonate, bis(1-undecanoxy-2,2,6,6-tetramethylpiperidine-4-yl) carbonate, 1,3,5-triazine-2,4,6-triamine, and N2,N2"-1,2-ethanediylbis[(N2-[3-[[4,6-bis[butyl(1,2,2,6,6-pentamet hyl-4-piperidinyl)amino]-1,3,5-triazine-2-yl]amino]propyl)]-N',N"-dibutyl-N',N"-bis(1,2,2,6-pentamethyl-4-piperidinyl) .

Moreover, specific examples of an NOR-type hindered amine compound having a group represented by formula (1) described above include TINUVIN XT850 (trade name, BASF Japan, Ltd.), and a reaction product of peroxidation-treated 4-butylamino-2,2, 6, 6-tetramethylpiperidine, and 2,4,6-trichloro-1,3,5-triazine, and cyclohexane and N,N'-ethane-1,2-diylbis(1,3-propanediamine). Among the compounds, preferred examples include a reaction product of peroxidation-treated 4-butylamino-2,2,6,6-tetramethylpiperidine, and 2,4,6-trichloro-1,3,5-triazine and cyclohexane and N,N'-ethane-1,2-diylbis(1,3-propanediamine).

When the resin composition for the solar cell encapsulant material according to the invention contains copolymer (b-2) as copolymer (B) and further contains the weakly basic light stabilizer described above, a decrease of adhesion strength with glass and light resistance that may be caused when copolymer (b-2) as copolymer (B) and a common light stabilizer are simultaneously used can be prevented.

In the respect, Patent literature No. 4 described above discloses an example in which a silane coupling agent and a NOR-type hindered amine flame retardant (weakly basic light stabilizer) are added to an ethylene-butene copolymer, but a constitution of a base resin is different, and no description is made on adhesion strength with glass, and light resistance is also unclear.

A content of the light stabilizer used in the invention is preferably in the range of 0.05 to 1.0% by weight, and further preferably, in the range of 0.1 to 0.8% by weight, based on the total amount of the resin composition for the solar cell encapsulant material.

### (Ultraviolet light absorber)

The ultraviolet light absorber used in the invention is applied to absorb harmful ultraviolet light in solar light to convert the absorbed light into harmless heat energy and to improve the light resistance of the solar cell encapsulant material. Specific examples of the ultraviolet light absorber include: salicylates such as phenyl salicylate, p-t-butylphenyl salicylate and p-octylphenyl salicylate; benzophenones such as 2,4-dihydroxybenzophenone, 2-hydroxy-4-methoxybenzophenone, 2-hydroxy-4-octoxybenzophenone, 2-hydroxy-4-dodecyloxybenzophenone, 2,2'-dihydroxy-4-methoxybenzophenone, 2,2'-dihydroxy-4,4'-dimethoxybenzophenone and 2-hydroxy-4-methoxy-5-sulfobenzophenone; benzotriazoles, such as 2-(2'-hydroxy-5'-methylphenyl)benzotriazole, 2-(2'-hydroxy-5'-tert-butylphenyl)benzotriazole, 2-(2'-hydroxy-3',5'-di-tert-butylphenyl)benzotriazole, 2-(2'-hydroxy-3'-tert-butyl-5'-methylphenyl)-5-chlorobenzotriazole, 2-(2'-hydroxy-3',5'-di-tert-butylphenyl)-5-chlorobenzotriazole, 2-(2'-hydroxy-3',5'-di-tert-amylphenyl)benzotriazole and 2-{(2'-hydroxy-3",4",5",6"-tetrahydrophthalimidomethyl)-5'-met hylphenyl}benzotriazole; benzoates such as 2,4-di-tert-butylphenyl-3,5-di-tert-butyl-4-hydroxybenzoate; and metal oxides such as titanium dioxide and zinc oxide.

A content of the ultraviolet light absorber used in the invention is preferably in the range of 0.05 to 1.0% by weight, further preferably, in the range of 0.1 to 0.6% by weight, based on the total amount of the resin composition for the solar cell encapsulant material.

### (Nucleating agent)

The nucleating agent used in the invention is applied in order to increase the transparency and the heat resistance of the solar cell encapsulant material. Specific examples include a sorbitol nucleating agent such as 1,3-chlorobenzyliene-2,4-methylbenzylidene sorbitol, 1,3,2,4-dibenzylidene sorbitol, 1,3,2,4-di(p-methylbenzylidene)sorbitol, 1,3,2,4-di(p-ethylbenzylidene)sorbitol and 1,3:2,4-bis-O-dimethylbenzyliene-D-sorbitol, a phosphate metal salt nucleating agent such as bis(2,4,8,10-tetra-tert-butyl-6-hydroxy-12H-dibenzo[d,f][1,3,2] dioxaphosphocin-6-oxide) aluminum hydroxide salt, an inorganic nucleating agent such as boehmite, zeolite, talc, titanium dioxide, mica and hydrotalcite, a non-acetal nucleating agent such as tris(methylcyclohexyl)propane tricarboxamide and dicyclohexyl naphthalenedicarboxamide; Rikemaster CN-001 (trade name, Riken Vinyl Industry Co., Ltd.) and Rikemaster CN-002 (trade name, Riken Vinyl Industry Co., Ltd.). The nucleating agents can be used alone or as a mixture.

Among the nucleating agents, Rikemaster CN-001, tris(methylcyclohexyl)propane tricarboxamide and dicyclohexyl naphthalenedicarboxamide are preferably used in the invention.

A content of the nucleating agent used in the invention is preferably in the range of 0.01 to 5. 0% by weight, and further preferably, in the range of 0.05 to 3.0% by weight, based on the total amount of the resin composition for the solar cell encapsulant material.

Among the nucleating agents described above, Rikemaster CN-001 (trade name, Riken Vinyl Industry Co., Ltd.) and Rikemaster CN-002 (trade name, Riken Vinyl Industry Co., Ltd.) are preferably added in an amount of 0.5 to 5.0% by weight based on the total amount of the resin composition for the solar cell encapsulant material.

### Solar cell encapsulant material

The solar cell encapsulant material is obtained by processing the resin composition for the solar cell encapsulant material by a conventionally known method, and is preferably processed into a sheet or film form.

In general, a surface temperature of the solar cell module may reach 80°C depending on a use environment by heat generation, radiation heat of solar light or the like during power generation in several cases. If a heat-resistance temperature is 100°C or higher, the heat resistance of the solar cell encapsulant material according to the invention can be secured and flow or deformation of the encapsulant material by heat generation can be prevented, and therefore such a temperature is preferred. In the invention, a 0.45 mm-thick sheet-formed solar cell encapsulant material is interposed between 3 mm-thick white glass plates (size; 100 mm in height and 100 mm in width), and a sample subjected to lamination, heating and press under conditions of 150°C and 10 minutes using a vacuum laminator is prepared. The sample is placed by being inclined at 60° in a constant-temperature bath at 100°C, and a state after lapse of 100 hours is observed. Superiority or inferiority of the heat resistance is evaluated as follows: a sample in which the glass plate causes no slip from an initial reference position is rated as "O," and a sample in which the glass plate causes slip from the initial reference position or the encapsulant material is melted is rated as "X."

Further, when photoelectric conversion efficiency of a solar cell or a visual aspect thereof as a commercial product is taken into consideration, the solar cell encapsulant material desirably has a high light transmittance and a low haze value. In the invention, a 0.45 mm-thick sheet-formed solar cell encapsulant material is inserted between 3 mm-thick white glass plates (size; 100 mm in height and 100 mm in width), and a sample subjected to lamination, heating and pressing under conditions of 150°C and 10 minutes using a vacuum laminator is prepared, and measurement is carried out by an ordinary method using a haze meter, an SM color computer or the like. Specifically, the total light transmittance is preferably 85% or more and the haze value is preferably 30% or less, and the total light transmittance is further preferably 88% or more and the haze value is further preferably 20% or less.

Moreover, the solar cell encapsulant material has a role of sealing the solar cell device between a protective material on a side of a light-receiving surface and a protective material on a side of a light-non-receiving surface, and preferably has high adhesion with each protective material. In the invention, a PTFE sheet is interposed between a 3 mm-thick white glass plate (size; 100 mm in height, 100 mm in width) and a PET backsheet made by Toray Advanced Film Co. Ltd. (trade name: LTW-01S), and a 0.45 mm-thick encapsulant material such that an adhesion length of both becomes 40 mm, and the resultant material is subjected to lamination, heating and pressing under conditions of 150°C and 10 minutes using a vacuum laminator, and a sample is prepared. The resultant laminated sample is used, and adhesion strength between the encapsulant material and the protective material on the side of the light-receiving surface and between the encapsulant material and the protective material on the side of the light-non-receiving surface is measured in a peeling test at 180° under a 25°C atmosphere. Specifically, the adhesion strength is preferably 5 N/15 mm width or more, further preferably 10 N/15 mm width or more, and still further preferably 15 N/15 mm width or more.

The adhesion strength described above is measured under peeling test conditions described below.
Testing machine: Tensile testing machine Autograph AGS-X made by Shimadzu Corporation
Measurement angle: peeling at 180°
Peeling rate: 100 mm/min

Moreover, the solar cell encapsulant material preferably retains the adhesion over a long period of time. Thus, the sample described above is left for 1,000 hours under high-temperature and high-humidity conditions of a temperature of 85°C and a relative humidity of 85%, and then provided for an accelerated light resistance test, using a sunshine weather meter, under conditions of an irradiance of 255 W/m², a black panel temperature of 83°C (without rainfall), and an irradiation time of 2,000 hr. Then, the adhesion strength between the white glass plate and the PET backsheet measured by the peeling test at 180° under the 25°C atmosphere is preferably 5 N/15 mm width or more, further preferably, 10 N/15 mm width or more, and still further preferably, 15 N/15 mm width or more. In addition, as a measurement method, a method in a manner similar to the method described above is applied.

Moreover, a thickness of the solar cell encapsulant material is preferably in the range of 50 to 2,000 micrometers, and particularly preferably in the range of 100 to 1,000 micrometers. If the thickness is in the range described above, damage is hard to occur in the cell, and workability in a laminating step during forming the module or during installing the module or the like becomes satisfactory, and such thickness is also advantageous in terms of cost.

The solar cell encapsulant material can be formed of a monolayer structure, or a multilayer structure having two or more layers. When the adhesion with the protective material on the side of the light-receiving surface such as the glass or with the solar cell device is required, the resin composition for the solar cell encapsulant material containing the copolymer (b-2) may be used in the form of a monolayer. However, for an economic aspect, the solar cell encapsulant material is preferably formed of the multilayer structure in which the resin composition for the solar cell encapsulant material containing the copolymer (b-2) is used only for the surface layer in contact with the protective material on the side of the light-receiving surface such as the glass, and the resin composition for the solar cell encapsulant material containing the copolymer (b-1) is used for other layers. Furthermore, when the recycling efficiency of the solar cell device is taken into consideration, the resin composition for the solar cell encapsulant material containing the copolymer (b-2) is preferably used only for the surface layer of the protective material on the side of the light-receiving surface such as the glass, and the resin composition for the solar cell encapsulant material that contains the copolymer (b-1) and does not contain the copolymer (b-2) is preferably used to prepare the encapsulant material of the layer not in contact with the protective material on the side of the light-receiving surface such as the glass, and the layer on the side of the light-non-receiving surface side.

For the surface layer described above, the resin composition for the solar cell encapsulant material into which the copolymer (b-1) in addition to the copolymer (b-2) is incorporated may be used. For a layer other than the surface layer, a product obtained by shaping the resin composition for the solar cell encapsulant material containing the copolymer (b-1) alone, containing the copolymer (b-2) alone or containing a mixture of the copolymers can be used.

In addition, the encapsulant material obtained by shaping the resin composition for the solar cell encapsulant material into which no copolymer (b-2) is incorporated can be adhered with the protective material on the side of the light-receiving surface, such as the glass, or the solar cell device by simultaneously using any other encapsulant material for the solar cell device having the adhesion with the protective material on the side of the light-receiving surface, such as the glass, or the solar cell device.

More specifically, with regard to the resin composition for the solar cell encapsulant material according to the invention, the encapsulant material obtained by shaping the resin composition does not need to have the adhesion with the substrate or the solar cell device or the like.

A thickness of the surface layer that constitutes the solar cell encapsulant material is preferably in the range of 10 to 100 micrometers, and particularly preferably, in the range of 20 to 80 micrometers. If the thickness is in the range described above, a uniform thickness of the surface layer is obtained, a fluctuation is hard to be caused in the adhesion with the protective material on the side of the light-receiving surface, and the protective material on the side of the light-non-receiving surface, and such thickness is also advantageous in terms of cost.

### Method for producing solar cell encapsulant material

Next, a method for producing the solar cell encapsulant material formed of the resin composition for the solar cell encapsulant material according to the invention is described.

A method for shaping the solar cell encapsulant material according to the invention is not particularly limited, if a sheet-formed multilayer shaped product can be obtained. For example, a publicly known method such as a T die extrusion casting method and an inflation method can be applied. The T die extrusion casting method is ordinarily preferably applied in view of handling properties, productivity or the like. A shaping temperature is appropriately adjusted by flow characteristics, film-forming properties or the like of the resin composition for the solar cell encapsulant material to be used, and is generally 130 to 230°C, and preferably, 150 to 200°C. The resin composition for the solar cell encapsulant material used for sheet forming may be supplied into an extruder installed in a sheet-forming apparatus, after dry-blending of various kinds of arbitrary additives such as an antioxidant, an ultraviolet light absorber and a light stabilizer with a resin beforehand, or may be supplied thereinto after melting and mixing all the materials to prepare pellets beforehand, or may be supplied thereinto, with other raw materials, after preparing a masterbatch in which the additives are concentrated in the resin beforehand. Moreover, embossing can be applied to a front or rear surface of the sheet-formed solar cell encapsulant material obtained by using the sheet-forming apparatus described above or the like in order to prevent blocking between the sheets, improve air bleed in the lamination step for the solar cell device, and prevent damage of the solar cell device, or the like.

### Solar cell module

Specific examples of a solar cell module according to the invention include a module formed of structure of a protective material on a side of a light-receiving surface - a encapsulant material - a solar cell device - a encapsulant material - a material for protecting a light-non-receiving surface, such as a crystalline silicon solar cell module, and a module formed of a structure of forming a encapsulant material and a protective material on a side of a light-non-receiving surface on a solar cell device that is formed on an inner surface of a protective material on a side of a light-non-receiving surface, such as a thin-film solar cell module.

### Method for producing solar cell module

Next, a method for producing the solar cell module constituted of the resin composition for the solar cell encapsulant material according to the invention is described. As the method for producing the solar cell module according to the invention, the solar cell module can be obtained by a laminating method in a manner similar to the conventional method in which the encapsulant sheet constituted of the resin composition for the solar cell encapsulant material is prepared in advance, the protective material on the side of the light-receiving surface, the solar cell device, the protective material on the side of the light-non-receiving surface and the encapsulant sheet are laminated in the order, the resultant laminate is provided for the vacuum laminator, and the laminated is pressed at temperature at which the encapsulant material is melted. In the case of the invention, in the solar cell encapsulant material, excellent heat resistance can be developed without containing the organic peroxide, production can be completed for a short period of time without needing passing through a crosslinking step for a long period of time in forming the module, and productivity of the module can be significantly improved.

### Protective material on a side of light-receiving surface

The protective material on the side of the light-receiving surface used for the solar cell module according to the invention is not particularly limited. However, the material is located on the side of the light-receiving surface for the solar cell module, and therefore the material preferably has performance of securing reliability over a long period of time in outdoor exposure of the solar cell module, including weather resistance, contamination resistance and mechanical strength such as an impact resistance and stiffness, and high transparency.

Specific examples of the protective material on the side of the light-non-receiving surface for the solar cell module include a glass substrate and a resin film formed of a polyester resin, a fluorocarbon resin, an acrylic resin and a cyclic olefin (co)polymer. Specific examples of the resin film preferably include a polyester film, particularly a polyethylene terephthalate film excellent in transparency, strength or cost, and a fluorocarbon resin film excellent in weather resistance. Specific examples of the fluorocarbon resin film include a film of a tetrafluoroethylene-ethylene copolymer (ETFE), a polyvinyl fluoride resin (PVF), a polyvinylidene fluoride resin (PVDF) and a tetrafluoroethylene-hexafluoropropylene copolymer (FEP) . Moreover, in order to improve the adhesion with an encapsulant material layer, corona treatment, plasma treatment or primer treatment is preferably applied to the protective material on the side of the light-receiving surface.

### Protective material on a side of light-non-receiving surface for solar cell module

The protective material on the side of the light-non-receiving surface used for the solar cell module according to the invention is not particularly limited, and is preferably excellent in various characteristics such as the weather resistance and mechanical strength in a manner similar to the protective material on the side of the light-receiving surface described above, and moisture-proof properties because the material is located in an outermost layer on the side of the light-non-receiving surface of the solar cell module, and to prevent corrosion of wiring in the module.

As the protective material on the side of the light-non-receiving surface, the transparency required for the protective material on the side of the light-receiving surface is not necessarily required. Therefore, specific examples of the protecting material include a single-layer or multilayer sheet of metal or various thermoplastic resin films, such as a single-layer or multilayer protecting material of metal including aluminum and stainless steel, an inorganic material including glass, and polyester, an inorganic substance-deposited polyester, a fluorine-containing resin and polyolefin. Moreover, in a manner similar to the protective material on the side of the light-receiving surface, corona treatment, plasma treatment or primer treatment is preferably applied to the protective material on the side of the light-non-receiving surface to improve the adhesion with the encapsulant material layer.

### Solar cell device

The solar cell device used for the solar cell module is not particularly limited, if the device can generate power by utilizing a photovoltaic effect of a semiconductor. For example, various solar cell devices of a silicon semiconductor such as single crystal silicon, polycrystalline silicon and amorphous silicon, or a III-V group or II-VI group compound semiconductor, such as gallium-arsenide, copper-indium-selenide and cadmium-telluride can be used.

### Examples

The invention is described in detail by way of Examples below, but the invention is by no means limited by the Examples.

### (1) Crystal melting peak temperature (Tm) (°C)

A differential scanning calorimeter "EXSTAR DSC 7020" (trade name) made by SII NanoTechnology Inc. was used to determine a crystal melting peak temperature (Tm) (°C), according to JIS K7121, from a thermogram measured when about 10 mg of a sample was heated from -40°C to 200°C at a heating rate of 10°C/min, the temperature was kept at 200°C for 5 minutes, and then the temperature was decreased to -40°C at a cooling rate of 10°C/min and then the temperature was again increased to 200°C at a heating rate of 10°C/min.

### (2) Heat resistance

A 0.45 mm-thick sheet-formed solar cell encapsulant material was inserted between two sheets of 3 mm-thick white glass plates (size; 100 mm in height and 100 mm in width), and a sample subjected to lamination, heating and pressing under conditions of 150°C and 10 minutes was prepared using a vacuum laminator "PVL0505S" made by Nisshin Toa Inc. Then, the sample was placed by being inclined 60° in a constant-temperature bath at 100°C, and a state after lapse of 100 hours was observed to evaluate the sample by criteria described below.
"O": a sample in which the glass plate caused no slip from an initial reference position.
"X": a sample in which the glass plate caused slip from the initial reference position or the sheet melted.

### (3) Total light transmittance, haze value (transparency)

A 0.45 mm-thick sheet-formed solar cell encapsulant material was inserted between two sheets of 3 mm-thick white glass plates (size; 100 mm in height and 100 mm in width), and a sample subjected to lamination, heating and pressing under conditions of 150°C and 10 minutes was prepared using a vacuum laminator "PVL0505S" made by Nisshin Toa Inc. Total light transmittance and a haze value were measured using a haze meter NDH5000 made by Nippon Denshoku Industries Co., Ltd.

### (4) Initial adhesion strength

A PTFE sheet was inserted between a 3 mm-thick white glass plate (size; 100mm in height and 100mm in width) and a 0.45 mm-thick encapsulant material such that an adhesion length of both became 40 mm, and a sample subjected to lamination, heating and pressing under conditions of 150 °C and 10 minutes was prepared using a vacuum laminator. The resultant laminated sample was used to measure adhesion strength between the encapsulant material and a protective material on a side of a light-non-receiving surface in a peeling test at 180°under a 25°C atmosphere.

### (5) Adhesion strength after light resistance test

A sample was prepared in a manner similar to preparation of the sample for measuring the initial adhesion strength. The resultant laminated sample was provided for a sunshine weather meter made by Suga Test Instruments Co., Ltd., and irradiated from a white glass plate surface under an irradiance of 255 W/m², a black panel temperature of 83°C (without rainfall), and an irradiation time of 2,000 hr. The resultant sample was used to measure adhesion strength between the encapsulant material and the protective material on the side of the light-receiving surface in a peeling test at 180° under a 25°C atmosphere.

### (Preparation of silane-modified copolymer (B)-4)

Then, 97.4% by weight of powder obtained by grinding a metallocene plastomer (trade name: Kernel KJ640T, MI: 30, Tm: 58°C, density: 0.880 g/cm³, made by Japan Polyethylene Corporation), 2% by weight of vinyltrimetoxysilane, 0.1% by weight of dicumyl peroxide, 0.1% by weight of a phenol-based antioxidant (trade name: Irganox 1010) and 0.1% by weight of a phosphorus-based antioxidant (trade name: Irgafos 168) were mixed, and the resultant mixture was melted and kneaded at 200°C, and then silane-modified copolymer (B)-4 (MI: 7.0, Tm: 58°C, density: 0.880 g/cm³) was obtained.

### (Preparation of light stabilizer masterbatch A)

Then, 89.8% by weight of powder obtained by grinding a metallocene plastomer (trade name: Kernel KS340T, MI: 3.5, Tm: 60°C, density: 0.880 g/cm³, made by Japan Polyethylene Corporation), 10.0% by weight of a light stabilizer (trade name: Flamestab NOR116), 0.1% by weight of a phenol-based antioxidant (trade name : Irganox 1010), and 0.1% by weight of a phosphorus-based antioxidant (trade name: Irgafos 168) were mixed, and the resultant mixture was melted and kneaded at 200°C, and thus light stabilizer masterbatch A was obtained.

### (Preparation of light stabilizer masterbatch B)

Then, 89.8% by weight of powder obtained by grinding a metallocene plastomer (trade name: Kernel KS340T, MI: 3.5, Tm: 60°C, density: 0.880 g/cm³, made by Japan Polyethylene Corporation), 10.0% by weight of a light stabilizer (trade name: TINUVIN XT850), 0.1% by weight of a phenol-based antioxidant (trade name: Irganox 1010) and 0.1% by weight of a phosphorus-based antioxidant (trade name: Irgafos 168) were mixed, and the resultant mixture was melted and kneaded at 200°C, and thus light stabilizer masterbatch B was obtained.

### (Preparation of ultraviolet light absorber masterbatch)

Then, 89.8% by weight of powder obtained by grinding a metallocene plastomer (trade name: Kernel KS340T, MI: 3.5, Tm: 60°C, density: 0.880 g/cm³, made by Japan Polyethylene Corporation), 10.0% by weight of a light stabilizer (trade name: TINUVIN 326), 0.1% by weight of a phenol-based antioxidant (trade name: Irganox 1010) and 0.1% by weight of a phosphorus-based antioxidant (trade name: Irgafos 168) were mixed, and the resultant mixture was melted and kneaded at 200°C, and thus an ultraviolet light absorber masterbatch was obtained.

### (Examples 1 to 2, Comparative Example 3)

A resin composition for a solar cell encapsulant material in which an ethylene-ethyl acrylate copolymer (trade name: UBE Polyethylene ZE708, ethyl-acrylate content: 15% by weight, MI: 0.5, Tm: 102°C, and density: 0.930 g/cm³, made by Ube Maruzen Polyethylene,) (hereinafter abbreviated as (A)-1) as ethylene-unsaturated fatty acid ester copolymer (A), and a metallocene plastomer (trade name: Kernel KS340T, MI: 3.5, Tm: 60°C, density: 0.880 g/cm³, made by Japan Polyethylene Corporation) (hereinafter, abbreviated as (B)-1) as ethylene-olefin random copolymer (b-1) were mixed at a ratio shown in Table 1 was melted and kneaded at a set temperature of 200°C using a 20 mm-diameter single screw multilayer extruder equipped with a T die to make three kinds and three layers to form a film using a casting roll at 20°C, and the resultant film was would around a paper tube having a diameter of 6 inches to obtain a 0.45 mm-thick sheet-formed solar cell encapsulant material. The results of evaluation using the sheet obtained are shown in Table 1.

With regard to initial adhesion strength, the sheet peeled from the white glass plate after preparation of a sample using a vacuum laminator, and therefore no measurement was allowed.

### (Example 3)

A 0.45 mm-thick sheet was obtained in a manner similar to Example 1 except that ethylene-unsaturated fatty acid ester copolymer (A) was changed to an ethylene-ethyl acrylate copolymer (A)-2 (trade name: UBE Polyethylene ZE709, ethyl acrylate content: 20% by weight, MI: 0.5, Tm: 100°C, and density: 0.930 g/cm³ made by Ube Maruzen Polyethylene) in Example 2. The results of evaluation using the sheet obtained are shown in Table 1.

With regard to initial adhesion strength, the sheet peeled from the white glass plate after preparation of a sample using a vacuum laminator, and therefore no measurement was allowed.

### (Example 4)

A 0.45 mm-thick sheet was obtained in a manner similar to Example 1 except that ethylene-olefin random copolymer (b-1) was changed to silane-modified copolymer (B)-4 in Example 1. The results of evaluation using the sheet obtained are shown in Table 1.

### (Example 5)

A 0.45 mm-thick sheet was obtained in a manner similar to in Example 1 except that ethylene-olefin random copolymer (b-1) was changed to silane-modified copolymer (B)-4 in Example 2. The results of evaluation using the sheet obtained are shown in Table 1.

### (Example 6)

A 0.45 mm-thick sheet was obtained in a manner similar to Example 1 except that ethylene-olefin random copolymer (b-1) was changed to silane-modified copolymer (B)-4 in Example 3. The results of evaluation using the sheet obtained are shown in Table 1.

### (Example 7)

A 0.45 mm-thick sheet was obtained in a manner similar to Example 1 except that 4% by weight of silane-modified copolymer (B)-4 was changed to 2% by weight of light stabilizer MB-A and 2% by weight of ultraviolet light absorber MB in Example 5. The results of evaluation using the sheet obtained are shown in Table 1.

### (Example 8)

A 0.45 mm-thick sheet was obtained in a manner similar to Example 1 except that light stabilizer MB-A was changed to light stabilizer MB-B in Example 7. The results of evaluation using the sheet obtained are shown in Table 1.

### (Comparative Example 1)

A 0.45 mm-thick sheet was obtained in a manner similar to Example 1 except that a resin composition for sealing a solar cell was changed to (A)-1 alone in Example 1. The results of evaluation using the sheet obtained are shown in Table 1. With regard to initial adhesion strength, the sheet peeled from the white glass plate after preparation of a sample using a vacuum laminator, and therefore no measurement was allowed.

### (Comparative Example 2)

A 0.45 mm-thick sheet was obtained in a manner similar to Example 1 except that a resin composition for sealing a solar cell was changed to (B)-1 alone in Example 1. The results of evaluation using the sheet obtained are shown in Table 1. With regard to initial adhesion strength, the sheet peeled from the white glass plate after preparation of a sample using a vacuum laminator, and therefore no measurement was allowed.

### (Comparative Example 4)

A 0.45 mm-thick sheet was obtained in a manner similar to Example 1 except that ethylene-olefin random copolymer (B) was changed to metallocene plastomer (B)-2 (trade name: Kernel KF270, MI: 2.0, Tm: 100°C, density: 0.907 g/cm³, made by Japan Polyethylene Corporation) in Example 2. The results of evaluation using the sheet obtained are shown in Table 1. With regard to initial adhesion strength, the sheet peeled from the white glass plate after preparation of a sample using a vacuum laminator, and therefore no measurement was allowed.

### (Comparative Example 5)

A 0.45 mm-thick sheet was obtained in a manner similar to Example 1 except that ethylene-olefin random copolymer (B) was changed to metallocene linear low density polyethylene (B)-3 (trade name: Umerit 3540F, MI: 4.0, Tm: 123°C, density: 0.931 g/cm³, made by Ube Maruzen Polyethylene) in Example 2. The results of evaluation using the sheet obtained are shown in Table 1. With regard to initial adhesion strength, the sheet peeled from the white glass plate after preparation of a sample using a vacuum laminator, and therefore no measurement was allowed.

### (Comparative Example 6)

A 0.45 mm-thick sheet was obtained in a manner similar to Example 1 except that ethylene-unsaturated fatty acid ester copolymer (A) was changed to ethylene-ethyl acrylate copolymer (A)-3 (trade name: Rexpearl A4250, a content of ethyl acrylate: 25% by weight, MI: 5, Tm: 92°C, density: 0.934 g/cm³, made by Japan Polyethylene Corporation) in Example 2. The results of evaluation using the sheet obtained are shown in Table 1. With regard to initial adhesion strength, the sheet peeled from the white glass plate after preparation of a sample using a vacuum laminator, and therefore no measurement was allowed.

### (Comparative Example 7)

A 0.45 mm-thick sheet was obtained in a manner similar to Example 1 except that a material composing a resin composition for a solar cell encapsulant material was changed to (B) -1 and (B) -2 in Example 1. The results of evaluation using the sheet obtained are shown in Table 1. With regard to initial adhesion strength, the sheet peeled from the white glass plate after preparation of a sample using a vacuum laminator, and therefore no measurement was allowed.

**Table 1**

| | | | Examples | | | | | | Comparative Examples | | | | | | |
|---|---|---|---|---|---|---|---|---|---|---|---|---|---|---|---|
| | | | 1 | 2 | 3 | 4 | 5 | 6 | 1 | 2 | 3 | 4 | 5 | 6 | 7 |
| A | Ethylene-unsaturated fatty acid ester copolymer | (A)-1 | 10 | 20 | - | 10 | 20 | - | 100 | - | 50 | 20 | 20 | - | - |
| | | (A)-2 | - | - | 20 | - | - | 20 | - | - | - | - | - | - | - |
| | | (A)-3 | - | - | - | - | - | - | - | - | - | - | - | 20 | - |
| B | Ethylene-olefin random copolymer | (B)-1 | 90 | 80 | 80 | - | - | - | - | 100 | 50 | - | - | 80 | 90 |
| | | (B)-2 | - | - | - | - | - | - | - | - | - | 80 | - | - | 10 |
| | | (B)-3 | - | - | - | - | - | - | - | - | - | - | 80 | - | - |
| | Silane-modified resin | (B)-4 | - | - | - | 90 | 80 | 80 | - | - | - | - | - | - | - |
| Light-resistant MB | Light stabilizer MB-A (weakly basic) | | - | - | - | - | - | - | - | - | - | - | - | - | - |
| | Light stabilizer MB-B (weakly basic) | | - | - | - | - | - | - | - | - | - | - | - | - | - |
| | Ultraviolet light absorber MB | | - | - | - | - | - | - | - | - | - | - | - | - | - |
| Sheet total thickness (mm) | | | 0.45 | 0.45 | 0.45 | 0.45 | 0.45 | 0.45 | 0.45 | 0.45 | 0.45 | 0.45 | 0.45 | 0.45 | 0.45 |
| Heat resistance | | | ○ | ○ | ○ | ○ | ○ | ○ | ○ | X | ○ | ○ | ○ | X | ○ |
| Total light transmittance (%) | | | 88 | 87 | 87 | 88 | 87 | 87 | 86 | 89 | 87 | 85 | 86 | 88 | 84 |
| Haze value (%) | | | 18 | 22 | 18 | 19 | 24 | 20 | 59 | 8 | 35 | 48 | 89 | 15 | 20 |
| Initial adhesion strength (N/15 mm) | | | UM | UM | UM | 40 | 33 | 35 | UM | UM | UM | UM | UM | UM | UM |

| | | | | | | | | | | | | | | | |
|---|---|---|---|---|---|---|---|---|---|---|---|---|---|---|---|
| Abbreviations: UM: unmeasurable | | | | | | | | | | | | | | | |

**Table 2**

| | | Examples | |
|---|---|---|---|
| | | 7 | 8 |
| Ethylene-unsaturated fatty acid ester copolymer (A)-1 | | 20 | 20 |
| Silane-modified resin (B)-4 | | 76 | 76 |
| Light-resistant MB | Light stabilizer MB-A (weakly basic) | 2 | - |
| | Light stabilizer MB-B (weakly basic) | - | 2 |
| | Ultraviolet light absorber MB | 2 | 2 |
| Sheet total thickness (mm) | | 0.45 | 0.45 |
| Heat resistance | | ○ | ○ |
| Total light transmittance (%) | | 87 | 87 |
| Haze Value (%) | | 24 | 24 |
| Initial adhesion strength (N/15 mm) | | 30 | 33 |
| Adhesion strength after light resistance treatment (N/15 mm) | | 35 | 36 |

The resins used in Examples and Comparative Examples are as described below.
(A) -1: Ethylene-ethyl acrylate copolymer (trade name: UBE Polyethylene ZE708, ethyl-acrylate content: 15% by weight, MI: 0.5 g/10 min, Tm: 102°C, density: 0.930 g/cm³, made by Ube Maruzen Polyethylene);
(A) -2: Ethylene-ethyl acrylate copolymer (trade name: UBE Polyethylene ZE709, ethyl-acrylate content: 20% by weight, MI: 0.5 g/10 min, Tm: 100°C, density: 0.932 g/cm³, made by Ube Maruzen Polyethylene);
(A)-3: Ethylene-ethyl acrylate copolymer (trade name: Rexpearl A4250, content of ethyl acrylate: 25% by weight, MI: 5 g/10 min, Tm: 92°C, density: 0.934 g/cm³, made by Japan Polyethylene Corporation);
(B)-1: Metallocene plastomer (trade name: Kernel KS340T, MI: 3.5 g/10 min, Tm: 60°C, density: 0.880 g/cm³, made by Japan Polyethylene Corporation);
(B)-2: Metallocene plastomer (trade name: Kernel KF270, MI: 2.0 g/10 min, Tm: 100°C, density: 0.907 g/cm³, made by Japan Polyethylene Corporation);
(B) -3: Metallocene linear low density polyethylene (trade name: Umerit 3540F, MI: 4.0 g/10 min, Tm: 123°C, density: 0.931 g/cm³, made by Ube Maruzen Polyethylene);
(B)-4: Vinyltrimethoxysilane-modified metallocene linear low density polyethylene (MI: 7.0 g/10 min, Tm: 58°C, density: 0.880 g/cm³).
Light-stabilizer MB-A: Light stabilizer master batch containing 10% by weight of hindered amine light stabilizer A (trade name: FLAMESTAB NOR116) ;
Light-stabilizer MB-B: Light stabilizer master batch containing 10% by weight of hindered amine light stabilizer A (trade name: TINUVIN XT850) ;
Ultraviolet light absorber MB: Ultraviolet light absorber master batch containing 10% by weight of benzotriazole ultraviolet light absorber (trade name: TINUVIN326).

### Industrial applicability

A solar cell encapsulant material of the invention is of a non-crosslinking type and has excellent balance regarding heat resistance, transparency and versatility.

The solar cell encapsulant material of the invention requires no use of a radical generator during producing a solar cell module, and therefore not only can significantly improve productivity in lamination in a step of producing the solar cell module, and productivity in a laminating step but also has excellent cell recycling efficiency due to the non-crosslinking type, and thus can significantly reduce cost of producing the solar cell module.

In particular, as is different from the invention described in Patent literature 1, the present invention requires, when an ethylene-vinyl acetate copolymer (EVA) is used as a encapsulant material, no operation of decomposing a radical generator such as an organic peroxide to crosslink EVA, in the lamination and the laminating step described above.

The solar cell encapsulant material of the invention has excellent heat resistance, and therefore if temperature rises in using the solar cell module, a problem in which the encapsulant material flows or deforms can be avoided, and appearance of the solar cell is not damaged.

The solar cell module that is inexpensive and has excellent performance is provided by using the solar cell encapsulant material of the invention.

## Claims

1. A resin composition for a solar cell encapsulant material, containing: 5 to 30% by weight of ethylene-unsaturated fatty acid ester copolymer (A) having a crystal melting peak temperature of 95 to 110°C as measured at a heating rate of 10°C/min in differential scanning calorimetry, and having an unsaturated fatty acid ester content of 10 to 23% by weight; and 95 to 70% by weight of at least one kind of copolymer (B) selected from ethylene-olefin random copolymer (b-1) having a crystal melting peak temperature lower than 80°C, and copolymer (b-2) obtained by copolymerizing alkoxysilane having a polymerizable functional group and the ethylene-olefin random copolymer (b-1).

2. The resin composition for the solar cell encapsulant material according to claim 1, wherein ethylene-unsaturated fatty acid ester copolymer (A) is an ethylene-alkyl acrylate copolymer.

3. The resin composition for the solar cell encapsulant material according to claim 1 or 2, wherein ethylene-unsaturated fatty acid ester copolymer (A) is an ethylene-ethyl acrylate copolymer.

4. The resin composition for the solar cell encapsulant material according to any one of claims 1 to 3, wherein the copolymer (B) is the ethylene-olefin random copolymer (b-1).

5. The resin composition for the solar cell encapsulant material according to any one of claims 1 to 3, wherein the copolymer (B) is copolymer (b-2) obtained by copolymerizing alkoxysilane having a polymerizable functional group and the ethylene-olefin random copolymer (b-1).

6. The resin composition for the solar cell encapsulant material according to any one of claims 1 to 3 and 5, further containing a weakly basic light stabilizer.

7. A solar cell encapsulant material obtained by shaping the resin composition for the solar cell encapsulant material according to any one of claims 1 to 6.

8. A solar cell module obtained by using the solar cell encapsulant material according to claim 7.

## Patentansprüche

1. Harzzusammensetzung für ein Solarzellen-Einkapselungsmaterial, enthaltend: 5 bis 30 Gew.-% Ethylen-ungesättigter Fettsäureester-Copolymer (A) mit einer Kristallschmelzpeaktemperatur von 95 bis 110°C, gemessen bei einer Erwärmungsrate von 10°C/min in Differentialscanningkalorimetrie, und mit einem ungesättigten Fettsäureesteranteil von 10 bis 23 Gew.-%, und 95 bis 70 Gew.-% von mindestens einer Art von Copolymer (B), ausgewählt aus statistischem Ethylen-Olefin-Copolymer (b-1) mit einer Kristallschmelzpeaktemperatur von weniger als 80°C, und Copolymer (b-2), erhalten durch Copolymerisieren von Alkoxysilan mit einer polymerisierbaren funktionalen Gruppe und dem statistischen Ethylen-Olefin-Copolymer (b-1).

2. Harzzusammensetzung für das Solarzellen-Einkapselungsmaterial gemäß Anspruch 1, wobei das Ethylen-ungesättiger Fettsäureester-Copolymer (A) ein Ethylen-Alkylacrylat-Copolymer ist.

3. Harzzusammensetzung für das Solarzellen-Einkapselungsmaterial gemäß Anspruch 1 oder 2, wobei das Ethylen-ungesättiger Fettsäureester-Copolymer (A) ein Ethylen-Ethylacrylat-Copolymer ist.

4. Harzzusammensetzung für das Solarzellen-Einkapselungsmaterial gemäß einem der Ansprüche 1 bis 3, wobei das Copolymer (B) das statistische Ethylen-Olefin-Copolymer (b-1) ist.

5. Harzzusammensetzung für das Solarzellen-Einkapselungsmaterial gemäß einem der Ansprüche 1 bis 3, wobei das Copolymer (B) Copolymer (b-2) ist, erhalten durch Copolymerisieren von Alkoxysilan mit einer polymerisierbaren funktionalen Gruppe und dem statistischen Ethylen-Olefin-Copolymer (b-1).

6. Harzzusammensetzung für das Solarzellen-Einkapselungsmaterial gemäß einem der Ansprüche 1 bis 3 und 5, weiter enthaltend einen schwach-basischen Lichtstabilisator.

7. Solarzellen-Einkapselungsmaterial, erhalten durch Formen der Harzzusammensetzung für das Solarzellen-Einkapselungsmaterial gemäß einem der Ansprüche 1 bis 6.

8. Solarzellen-Modul, erhalten unter Verwendung des Solarzellen-Einkapselungsmaterials gemäß Anspruch 7.

## Revendications

1. Composition de résine pour un matériau d'étanchéité pour cellules solaires, contenant : de 5 à 30% en poids d'un copolymère d'éthylène et d'ester d'acide gras insaturé (A) ayant une température de fusion cristalline maximale de 95 à 110°C telle que mesurée à une vitesse de chauffage de 10°C/min par calorimétrie différentielle à balayage, et ayant une teneur en ester d'acide gras insaturé de 10 à 23% en poids ; et de 95 à 70% en poids d'au moins une sorte de copolymère (B) choisi parmi un copolymère aléatoire d'éthylène et d'oléfine (b-1) ayant une température de fusion cristalline maximale inférieure à 80°C, et un copolymère (b-2) obtenu par copolymérisation d'un alcoxysilane ayant un groupe fonctionnel polymérisable et du copolymère aléatoire d'éthylène et d'oléfine (b-1) .

2. Composition de résine pour le matériau d'étanchéité pour cellules solaires selon la revendication 1, dans laquelle le copolymère d'éthylène et d'ester d'acide gras insaturé (A) est un copolymère d'éthylène et d'acrylate d'alkyle.

3. Composition de résine pour le matériau d'étanchéité pour cellules solaires selon la revendication 1 ou 2, dans laquelle le copolymère d'éthylène et d'ester d'acide gras insaturé (A) est un copolymère d'éthylène et d'acrylate d'éthyle.

4. Composition de résine pour le matériau d'étanchéité pour cellules solaires selon l'une quelconque des revendications 1 à 3, dans laquelle le copolymère (B) est le copolymère aléatoire d'éthylène et d'oléfine (b-1).

5. Composition de résine pour le matériau d'étanchéité pour cellules solaires selon l'une quelconque des revendications 1 à 3, dans laquelle le copolymère (B) est le copolymère (b-2) obtenu par copolymérisation d'un alcoxysilane ayant un groupe fonctionnel polymérisable et du copolymère aléatoire d'éthylène et d'oléfine (b-1).

6. Composition de résine pour le matériau d'étanchéité pour cellules solaires selon l'une quelconque des revendications 1 à 3 et 5, contenant en outre un photostabilisant légèrement basique.

7. Matériau d'étanchéité pour cellules solaires obtenu par mise en forme de la composition de résine pour le matériau d'étanchéité pour cellules solaires selon l'une quelconque des revendications 1 à 6.

8. Module de cellule solaire obtenu par utilisation du matériau d'étanchéité pour cellules solaires selon la revendication 7.
